(19) Europäisches Patentamt
European Patent Office
Office européen des brevets

(11) Veröffentlichungsnummer: **0 291 994 A2**

# (12) EUROPÄISCHE PATENTANMELDUNG

(21) Anmeldenummer: 88108095.6

(51) Int. Cl.4: G03F 7/10 , G03F 7/08

(22) Anmeldetag: 20.05.88

(30) Priorität: 22.05.87 US 52950

(43) Veröffentlichungstag der Anmeldung:
23.11.88 Patentblatt 88/47

(84) Benannte Vertragsstaaten:
AT BE CH DE FR GB IT LI NL SE

(71) Anmelder: HOECHST AKTIENGESELLSCHAFT
Postfach 80 03 20
D-6230 Frankfurt am Main 80(DE)

Anmelder: HOECHST CELANESE CORPORATION
Route 202-206 North
Somerville, N.J. 08876(US)

(72) Erfinder: Osuch, Christopher E.
151 A. Randolph Avenue
Mine Hill, N.J. 07801(US)
Erfinder: McFarland, Michael James
510 Helfin Street
Round Brook, N.J. 08805(US)

(74) Vertreter: Euler, Kurt Emil, Dr. et al
HOECHST AG - Werk KALLE Patentabteilung
Postfach 3540 Rheingaustrasse 190
D-6200 Wiesbaden(DE)

## (54) Photoresistgemisch und hiermit hergestelltes Photoresistmaterial enthaltend ein Polymer blockkierten Imidgruppen, sowie hierfür geeignetes Maleinsäureimidmonomer.

(57) Die Erfindung betrifft ein Photoresistgemisch und hiermit hergestelltes Photoresistmaterial, enthaltend ein Polymer mit Imidgruppen, die durch an Acetal- oder Ketaleinheiten gebundene Methylol- oder substituierte Methylolgruppen blockiert sind, z.B. der Formeln

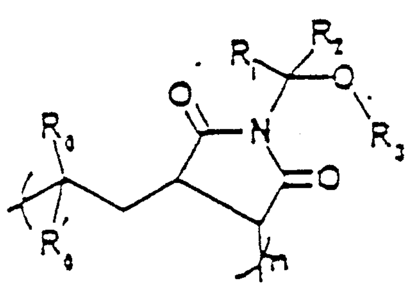

oder

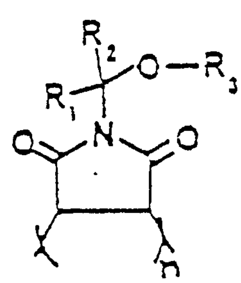

worin
$R_0$ Wasserstoff oder Methyl
$R_0'$ Aryl, Alkoxy oder Aryloxy,
$R_1$ und $R_2$ Wasserstoff oder ($C_1$ - $C_4$)-Alkyl,

EP 0 291 994 A2

$R_3$

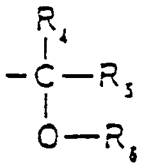 ,

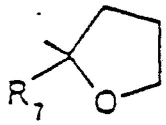 ,

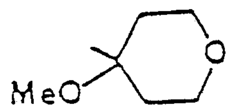 oder

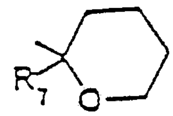

mit

$R_4$, $R_5$ Wasserstoff oder ($C_1$ - $C_4$)-Alkyl

$R_6$ ($C_1$ - $C_{10}$)-Alkyl

$R_7$ Wasserstoff oder ($C_1$ - $C_4$)-Alkyl

bedeuten,

eine bei Belichtung Säure abspaltende Verbindung, die die Acetal- oder Ketaleinheiten durch photolytisch bei einer erwünschten Wellenlänge gebildete Säure abspaltet, und ein Lösemittel, das Polymer und Säure abspaltende Verbindung löst.

Die Erfindung betrifft auch das Imidgruppen haltige Monomer wie ein Maleinsäureimidderivat, durch das das Polymer als Homo- oder Copolymerisat hergestellt werden kann. Das Polymer kann man in zwei Stufen abspalten, 1. bei der Bestrahlung in Gegenwart der Säure bildenden Verbindung und 2. bei der Entwicklung, so daß schließlich ein alkali-lösliches Polymer entsteht, das man in den bestrahlten Bereichen entfernen kann.

Das Photoresistmaterial ist besonders verwendbar für DUV-Strahlung und besitzt großes Auflösungsvermögen.

# Photoresistgemisch und hiermit hergestelltes Photoresistmaterial, enthaltend ein Polymer mit blockierten Imidgruppen, sowie hierfür geeignetes Maleinsäureimidmonomer

Die Erfindung betrifft ein Photoresistgemisch und ein hiermit hergestelltes Photoresistmaterial, enthaltend ein Polymer mit blockierten Imidgruppen. Die Erfindung betrifft auch ein blockiertes Maleinsäureimid, das zur Herstellung des Polymeren geeignet ist. Die blockierenden Gruppen an den Imideinheiten des Polymeren lassen sich in zwei Stufen abspalten, wobei in der ersten Stufe die Abspaltung bei Belichten des Photoresists mit aktinischer Strahlung erfolgt und in der zweiten Stufe während der anschließenden Entwicklung des latenten Bildes.

Es ist bekannt, positiv arbeitende Photoresistmaterialien durch die Kombination von bei Belichtung Säure abspaltenden Verbindungen, wie z.B. Estern von Naphthochinondiazidsulfonsäuren, mit alkalilöslichen Harzen, wie z.B. den bekannten Novolaken (Phenol-Formaldehyd-Kondensationsprodukten), herzustellen. Die Novolake sind in wäßrig-alkalischen Lösungen löslich und lassen sich daher während des Entwicklungsvorgangs entfernen. Wenn die bei Belichtung Säure abspaltende Verbindung jedoch eine unlösliche Substanz ist, so bleibt das Gemisch durch diese Substanz bis zur Belichtung mit aktinischer Strahlung unlöslich. Erst dann wird die Säure abspaltende Verbindung ebenso wie das Novolak harz alkalilöslich, so daß das Gemisch in den belichteten Bereichen der Photoresist-Oberfläche entfernt werden kann.

Neuerdings besteht ein großes Interesse am Einsatz von kurzwelliger UV-Strahlung (DUV) für die Belichtung, weil man damit das Auflösungsvermögen verbessern kann und somit kleinere Strukturen wiedergegeben werden können. Die Novolakharze sind für diesen Einsatz weniger geeignet, da sie DUV-Strahlung in hohem Maße absorbieren und die saubere Entwicklung des Bildes verhindern. Es besteht deshalb ein Bedürfnis nach Materialien, die keine DUV-Strahlung absorbieren. Ein solches Material wurde zum Beispiel in der nicht vorveröffentlichten U.S.-Patentanmeldung, Serial No. 814,591, als Copolymerisat von Maleinsäureimid und Comonomeren, wie z.B. substituiertem Styrol, vorgeschlagen. Diese Materialien sind zwar gegenüber den üblichen Novolaken sehr viel durchlässiger für DUV-Strahlung, sie haben aber immer noch gewisse Nachteile, so daß weitere Verbesserungen wünschenswert sind. Die nicht vorveröffentlichte US-PS 4,720,445 (U.S.-Patentanmeldung, Serial No. 829,874), schlägt ein abgeändertes Copolymerisat vor, in dem die Styrole durch verschiedene Vinylether oder -ester ersetzt sind. Nichtsdestoweniger sind weitere Verbesserungen notwendig.

Verschiedene Autoren beschreiben Polymere mit bestimmten absapltbaren Gruppen, gelegentlich auch "blockierende Gruppen" genannt. Durch diese Gruppen lassen sich die Eigenschaften der Polymeren verändern, wenn durch Bestrahlung des Sensibilisators die bei Belichtung Säure abspaltende Verbindung Säure freisetzt. Wird eine blockierende Gruppe zum Beispiel mit einem Novolakharz verbunden, das für sich allein in einer wäßrig-alkalischen Entwicklerlösung löslich ist, so kann es in ein wasserunlösliches Harz umgewandelt werden, das nur in den Bereichen nicht gegen die alkalische Lösung beständig ist, in denen die Säure abspaltende Verbindung belichtet wurde und dabei Säure freigegeben hat, durch die die blockierenden Gruppen von dem Novolakgemisch effektiv abgespalten werden, so daß das Gemisch wieder seine normale, alkali-lösliche Form annimmt. Ein derartiger Vorgang ist aus US-PS 3,779,778 bekannt. Auch die US-PS 4,491,628 beschreibt ein ähnliches photolytisches Verfahren, das auf ein anderes Polymer, nämlich ein Polyhydroxystyrol, angewandt wird.

Gemäß der nicht vorveröffentlichten U.S.-Patentanmeldung, Serial No. 832,116, werden blockierende Gruppen mit den Maleinsäureimid/Styrol- bzw. Maleinsäureimid/Vinylester-oder -ether-Copolymerisaten im Gemisch eingesetzt, um deren Wirkungsweise zu verbessern. Es hat sich gezeigt, daß mit diesen Copolymerisaten deutlich bessere Ergebnisse erzielt werden. Bei der Abspaltung der blockierenden Gruppen des Maleinsäureimid/Styrol- Polymers, die bei verhältnismäßig hohen Temperaturen stattfindet, müssen die Bedingungen jedoch sehr genau gesteuert werden. Vorzuziehen wäre ein Material, das sich nach der Bestrahlung der Säure abspaltenden Verbindung sowohl bei relativ niedrigen Temperaturen abspalten läßt, als auch eine weniger genaue Steuerung der Abspaltungsbedingungen erfordert, d.h. einen größeren Verfahrensspielraum läßt.

In US-PS 4,101,323 wird ein weiterer Aspekt des allgemeinen Prinzips beschrieben, nämlich die Abspaltung von blockierenden Gruppen mit Hilfe einer Säure, die bei der Bestrahlung einer Säure abspaltenden Verbindung erzeugt wird. Es könnte der Eindruck entstehen, daß z.B. die Verbindung 76 aus dieser Veröffentlichung den Verbindungen der Erfindung ähnlich ist, doch wird dort die blockierende Gruppe zur Bildung der löslichen Imidverbindung vollständig abgespalten, und damit ergibt sich kein Hinweis auf das erfindungsgemäße Merkmal einer zweistufigen Abspaltung. Ferner ist die bekannte Verbindung nicht in ein Polymer eingearbeitet.

Es war Aufgabe der Erfindung ein verbessertes Photoresistgemisch und ein hiermit hergestelltes Photoresistmaterial anzugeben, insbesondere für die Belichtung im DUV-Bereich, das bessere Verarbeitungseigenschaften aufweist und die gewünschten feineren Strukturen ergibt.

Erfindungsgemäß wird ein neues Monomer zur Herstellung von Homo- oder Copolymerisaten verwendet, die sich während der Verarbeitung von diese Polymere enthaltenden Photoresistgemischen in zwei Stufen abspalten lassen.

Erfindungsgemäß wird ein Photoresistgemisch beschrieben, enthaltend

a) ein Polymer mit Imidgruppen, die durch an Acetal- oder Ketaleinheiten gebundene Methylol- oder substituierte Methylolgruppen blockiert sind,

b) eine bei Belichtung Säure abspaltende Verbindung in einer Menge, die ausreicht, die Acetal- oder Ketaleinheiten durch die photolytisch bei einer erwünschten Wellenlänge gebildete Säure abzuspalten und

c) ein Lösemittel, das geeignet ist das Polymer nach a) und die Verbindung nach b) zu lösen. Vorzugsweise ist das Polymer ein Homopolymer eines blockierten Maleinsäureimids. Das Polymer kann auch ein Copolymerisat sein, das nicht mehr als fünf Comonomereinheiten pro blockierter Imidgruppe besitzt. Bevorzugt wird ein Polymer, das ein Copolymerisat ist, das etwa eine Comonomereinheit pro blockierter Imidgruppe besitzt.

Die Polymerisate besitzen eine säureempfindliche Acetal- oder Ketaleinheit, die bei der Bestrahlung der Säure abspaltenden Verbindung durch eine katalytische Reaktion abgespalten wird, wobei die Imidstickstoffatome noch durch eine Methylol- oder substituierte Methylolgruppe blockiert bleiben, die erst bei der Entwicklung des belichteten Gemischs in einer wäßrigalkalischen Lösung abgespalten wird.

Die erfindungsgemäßen Polymerisate enthalten eine Anzahl latenter Imidgruppen

$(-\overset{O}{\overset{\|}{C}}-NH-\overset{O}{\overset{\|}{C}}-)$, die ausreichen, um sie in wäßrig-alkalischen Entwicklerlösungen löslich zu machen. Diese Imidgruppen sind durch eine an eine Acetal- oder Ketaleinheit gebundene Methylol- oder substituierte Methylolgruppe blockiert. Das Polymerisat kann ein Homopolymeres des neuen Monomers sein oder auch ein Copolymerisat, in dem das Molverhältnis des Comonomeren zu der latenten Imidgruppe in dem neuen Monomer bis zu etwa 5 : 1, vorzugsweise etwa 1 : 1 beträgt.

Das Maleinsäureimidmonomer entspricht der folgenden allgemeinen Formel:

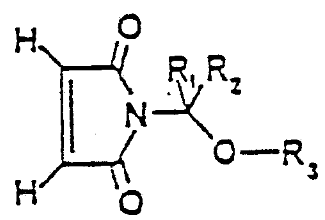

worin

$R_1$ und $R_2$ Wasserstoff oder $(C_1 - C_4)$-Alkyl und

$R_3$

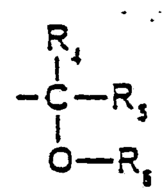

mit $R_4$ und $R_5$ Wasserstoff oder $(C_1 - C_4)$-Alkyl

und $R_6$ $(C_1 - C_{10})$-Alkyl,

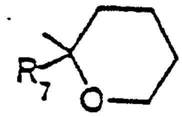

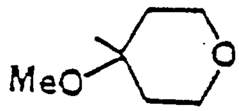

oder

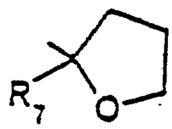

mit $R_7$ Wasserstoff oder $(C_1\text{-}C_4)$-Alkyl,
bedeuten.

Die Monomeren dieser Art sind neue Stoffzusammensetzungen, wie aus der nachfolgenden ausführlichen Beschreibung ersichtlich ist.

Die Homo- bzw. Copolymerisate entsprechen den Formeln

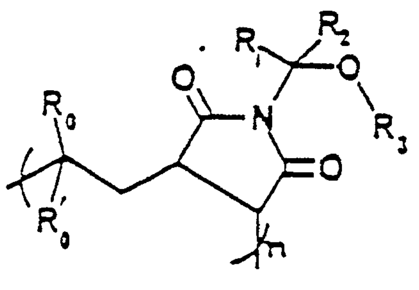

, oder

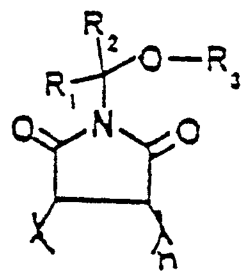

worin
$R_0$ Wasserstoff oder Alkyl, insbesondere Methyl
$R_0'$ Aryl, Alkoxy oder Aryloxy bedeuten und
$R_1$, $R_2$ und $R_3$ die oben im Zusammenhang mit dem Monomer angegebene Bedeutung haben.

Zu den besonders bevorzugten Ausführungen zählen Polymerisate, in denen $R_0$ Wasserstoff, $R_0'$ Phenyl und $R_1$ und $R_2$ Wasserstoff bedeuten.

Vorzugsweise wird ein Photoresistgemisch verwendet, enthaltend

a) 60 - 99 Gewichtsprozent, bezogen auf die nichtflüchtigen Bestandteile, des Imidgruppen haltigen Polymers folgender allgemeiner Formeln

oder

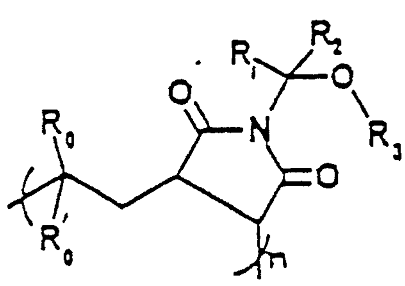

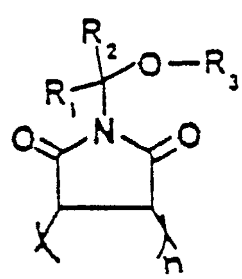

worin
$R_0$ - Wasserstoff oder Methyl
$R_0'$ Aryl, Alkoxy oder Aryloxy,
$R_1$ und $R_2$ Wasserstoff oder ($C_1$ - $C_4$)-Alkyl,
$R_3$

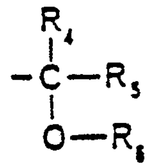

mit $R_4$ und $R_5$ Wasserstoff oder ($C_1$ - $C_4$)-Alkyl und $R_6$ ($C_1$ - $C_{10}$)-Alkyl

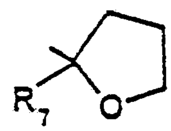

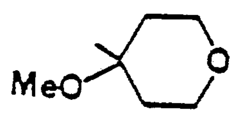

oder

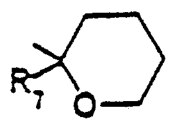

mit $R_7$ Wasserstoff oder ($C_1$ - $C_4$)-Alkyl
bedeuten,

b) 1 bis 40 Gewichtsprozent, bezogen auf die nichtflüchtigen Bestandteile, der bei Belichtung Säure abspal tenden Verbindung und

c) 1 bis 9 Gewichtsteile, bezogen auf die nichtflüchtigen Bestandteile, eines Lösemittels, das geeignet ist, das Polymer nach a) und die Verbindung nach b) zu lösen.

Bevorzugt wird ein Gemisch, worin
$R_0'$ Aryl oder substituiertes Aryl, vorzugsweise Phenyl, bedeutet, oder worin
$R_0'$-($C_1$-$C_{10}$)-Alkoxy, vorzugsweise n-Decyloxy bedeutet.

Vorteilhaft sind auch Gemische, worin
$R_3$ -$C(CH_3)_2$-O-$CH_3$ oder -$CH(CH_3)$-O-$CH_3$ und
$R_0'$ Phenyl oder

$R_3$

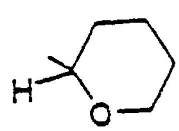

oder

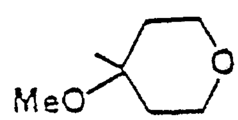

und

$R_0'$ Phenyl bedeuten.

Es können bekannte, bei Belichtung Säure abspaltende Verbindungen verwendet werden, wie die Sulfonsäureester eines Naphthochinondiazids, Oniumsalze oder Alkylhalogenide.

Als Oniumsalz sind Jodoniumsalze, wie ein Diaryljodoniumsalz, insbesondere Di-4-methylphenyl-, Di-4-methoxyphenyl-oder Diphenyl-jodoniumsalz oder Sulfoniumsalze, wie ein Triarylsulfoniumsalz, insbesondere Tri-4-methylphenyl-, Tri-4-methoxyphenyl- oder Triphenylsulfoniumsalz vorhanden.

Die Oniumsalze besitzen vorteilhaft ein Perfluoralkansulfonatanion, wie ein geradkettiges ($C_1$ - $C_{10}$)-

Alkansulfonat, vorzugsweise ein Perfluorpentan-, Perfluoroktan- oder Perfluormethan-sulfonat-anion oder ein Hexafluorphosphat-, Tetrafluorborat-oder Hexafluorarsenat-anion.

Das einsetzbare Alkylhalogenid als bei Belichtung Säure abspaltende Verbindung ist vorteilhaft ein Halogenkohlenwasserstoff mit geringer Flüchtigkeit, wie 2,4-Bis-(trichlormethyl)-6-p-methoxystyryl-s-triazin.

Das eingesetzte Jodonium- oder Sulfoniumsalz enthält vorzugsweise ein Anion, das in der Lage ist, aktinische Strahlung zu absorbieren und die aufgenommene Energie auf das Kation zu übertragen.

Die Erfindung betrifft auch ein Photoresistmaterial, bestehend aus einem Substrat und einer lichtempfindlichen Schicht, enthaltend

a) ein Polymer mit Imidgruppen, die durch an Acetal- oder Ketaleinheiten gebundene Methylol- oder substituierte Methylolgruppen blockiert sind, und

b) eine bei Belichtung Säure abspaltende Verbindung in einer Menge, die ausreichend ist, die Acetal- oder Ketaleinheiten durch die photolytisch bei einer erwünschten Wellenlänge gebildeten Säure abzuspalten.

Zur Herstellung eines erfindungsgemäßen Photoresistmaterials wird das Gemisch auf einen geeigneten Schichtträger aufgebracht und das Lösemittel nach den in der Praxis üblichen Verfahren vertrieben. Das Material kann dann zur Ausbildung der gewünschten Struktur insbesondere mit kurzwelligem UV-Licht (DUV) bestrahlt, anschließend zur vollständigen Abspaltung der Polymeren entsprechend erhitzt und mit wäßrig-alkalischen Lösungen entwickelt werden. Das resultierende Positivbild zeichnet sich durch scharf abgegrenzte Reliefkonturen aus, die gegen Temperaturen von etwa 230 °C beständig sind.

Aus den neuen monomeren Verbindungen können Polymere hergestellt werden, die zur Verwendung in Photoresists für die Mikrolithographie geeignet sind. Die aus den Monomeren entstandenen blockierten Polymerisate sind in alkalischen Lösungen unlöslich. Deswegen sind sie in den Bereichen, in denen sie nicht der Abspaltung unterworfen wurden, beständig gegen alkalische Entwicklerlösungen und führen zu einer scharfen Abgrenzung der Randlinien der bestrahlten Bereiche. An den Stellen, an denen die bei Belichtung Säure abspaltende Verbindung durch Umlagerung eine Brönsted-Säure entwickelt hat, wird die erste blockierende Gruppe katalytisch entfernt, während die zweite blockierende Gruppe an die Stickstoffatome gebunden bleibt. Die zweite blockierende Gruppe wird durch Behandlung mit wäßrigalkalischen Entwicklerlösungen entfernt, so daß nur die in den alkalischen Lösungen löslichen, unsubstituierten Imidgruppen

(- $\overset{O}{\overset{\|}{C}}$-NH- $\overset{O}{\overset{\|}{C}}$ -) zurückbleiben. Die Imidgruppen

(- $\overset{O}{\overset{\|}{C}}$ -NH- $\overset{O}{\overset{\|}{C}}$ -) machen Polymere in alkalischen Lösungen löslich. Die Alkalilöslichkeit erleichtert das Entfernen der Polymerisate beim Entwickeln des belichteten Bildes, im unbelichteten Bereich ist sie dagegen unerwünscht. Daher macht die erste blockierende Gruppe, bei der es sich um eine Acetal- oder Ketaleinheit handelt, den unbelichteten Bereich in der alkalischen Entwicklerlösung unlöslich. Es hat sich gezeigt, daß die Acetal oder Ketaleinheiten sich nicht leicht an den Imid enthaltenden Teil des Monomers binden lassen. Sie können jedoch indirekt an das Imid gebunden werden, wenn man zunächst Methylolmaleinsäureimid oder ein substituiertes Äquivalent davon herstellt und anschließend das gewünschte Acetal oder Ketal erzeugt. In dieser Erfindung soll unter "Methylol" die Gruppe $-CH_2OH$ oder das substituierte Äquivalent $-CR_1R_2OH$ verstanden werden. Da das Methylolmaleinsäureimid oder sein substituiertes Äquivalent durch Säure nicht blockiert wird, sondern in einer alkalischen Entwicklerlösung löslich wäre, könnte man diese Verbindung weniger gut in positiven Photoresistgemischen einsetzen. (Um die Lösungsfähigkeit des Polymerisats zu begrenzen, brauchte man eine unlösliche, bei Belichtung Säure abspaltende Verbindung.) Wenn jedoch die Acetal- oder Ketaleinheit an das erfindungsgemäße Monomere gebunden ist, läßt sich dieses in zwei Stufen blockieren, und nach der Polymerisation gibt es dem Photoresistgemisch hervorragende Eigenschaften.

Das erfindungsgemäße Monomer kann unter wasserfreien Bedingungen durch säurekatalytische Reaktion von Methylolmaleinsäureimid oder einem substituierten Äquivalent mit solchen Verbindungen hergestellt werden, die die oben bezeichneten Gruppen $R_3$ ergeben.

Es soll eine säureabbaubare Gruppe hergestellt werden, welche die Methylolmaleinsäureimidstruktur in sich schließt. Die oben beschriebenen Substituenten $R_4$, $R_5$, $R_6$ und $R_7$ werden je nach Verfügbarkeit des Reaktionsmittels, der Reaktionsfähigkeit mit Methylolmaleinsäureimid und der gewünschten Stabilität des endgültigen säureabbaubaren Polymeren gewählt.

Insbesondere sind Monomere der folgenden Formeln bisher nicht bekannt, und besonders vorteilhaft einsetzbar:

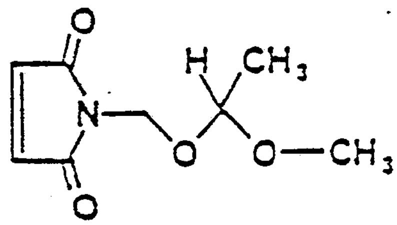

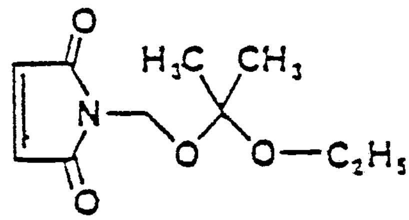

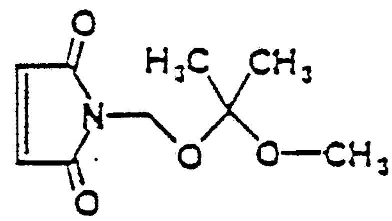

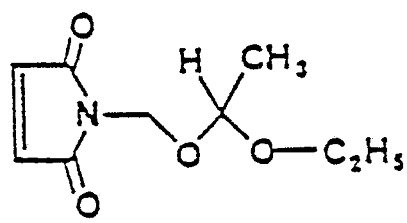

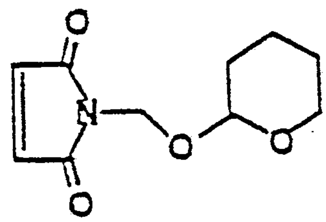

Insbesondere erfindungsgemäß geeignete Monomere sind N-(2,4-Dioxa-3,3-dimethyl-pentyl)-2H,5H-2,5-dioxopyrrol und N-(2,4-Dioxa-3-methylpentyl)-2H,5H-2,5-dioxopyrrol.

Die für den Einsatz in Photoresists geeigneten Harze bestehen aus Copolymerisaten oder Homopolymerisaten der erfindungsgemäßen Monomeren und entsprechen den folgenden Formeln:

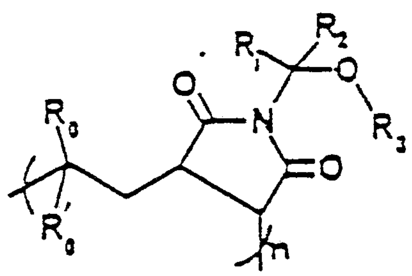

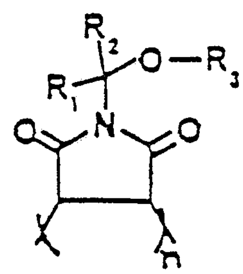

worin

$R_0$ Wasserstoff oder Methyl,

$R_0'$ Aryl, Alkoxy oder Aryloxy bedeuten und

$R_1$, $R_2$ und $R_3$ die oben im Zusammenhang mit dem Monomer angegebene Bedeutung haben.

Wenn $R_3$ durch die Wirkung der photochemisch gebildeten Säure abgespalten wird, bleibt die Methylolgruppe (worin $R_1$ und $R_2$ = H sind) oder ein substituiertes Äquivalent davon an den Stickstoff gebunden. Diese Gruppen werden durch die Einwirkung der alkalischen Entwicklerlösung entfernt, und es bleibt das Polymere mit der basischen Succinimidstruktur

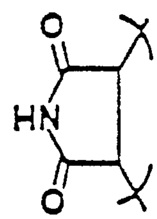

zurück, das in alkalischen Lösungen löslich ist, so daß es dann möglich ist, das belichtete Photoresistgemisch vollständig zu entfernen.

Diese Polymerisate können im allgemeinen durch normale radikalische Polymerisationstechniken aus den erfindungsgemäßen Monomeren allein (wenn man ein Homopolymeres erhalten will) oder durch Copolymerisation mit Comonomeren, welche die oben genannten $R_0$ - und $R_0'$-Gruppen enthalten, hergestellt werden.

Die erfindungsgemäßen Polymerisate müssen einen ausreichend großen Anteil an säureabspaltbaren Gruppen enthalten, so daß ein deutlicher Löslichkeitsunterschied zwischen bestrahlten und unbestrahlten Bereichen entsteht. Das Molverhältnis zwischen Comonomeren und substituiertem Methylolmaleinsäureimid liegt z.B. zwischen 0 und 1. Besonders vorteilhaft sind Verhältnisse von 0 (Homopolymer) und 1. Es hat sich gezeigt, daß bei einem größeren Comonomeranteil die Löslichkeit nachteilig beeinflußt wird, so daß das Molverhältnis etwa 5 : 1 nicht überschreiten soll.

Das Comonomer kann aus einer großen Gruppe von Vinylverbindungen gewählt werden. Am besten geeignet sind jedoch elektronenreiche Vinylverbindungen, wie z.B. Styrole oder Vinylether. Elektronenreiche Comonomere neigen dazu, bei der Polymerisation mit dem blockierten Methylolmaleinsäureimidmonomeren eine alternierende Struktur zu ergeben. Das hat den Vorteil, daß ein gleichförmiges Polymeres gebildet wird, bei dem jede Molekülkette etwa das gleiche Monomerenverhältnis aufweist, ohne daß spezielle Polymerisationstechniken angewendet werden müssen. Bevorzugte Comonomere sind Styrol, $\alpha$-Methylstyrol, Butylvinylether und Butyl-$\alpha$-methylvinylether.

Die radikalische Polymerisationsreaktion kann in herkömmlichen Lösemitteln durchgeführt werden, wie z.B. Ethylacetat, Cyclohexanon, Tetrahydrofuran oder Toluol. Das Lösemittel soll so gewählt werden, daß keine freien -OH-Gruppen vorhanden sind. Ferner soll das Lösemittel säure- und wasserfrei sein. Kettenübertragungsmittel, wie z.B. Thiole oder Disulfide, können zur Steuerung des endgültigen Molekulargewichts des Polymers zugesetzt werden. Es kann ein bekannter Polymerisationsinitiator verwendet werden, wobei die bevorzugten Initiatoren Bisazoverbindungen sind, wie z.B. Azo-bis-isobutyronitril oder, besonders bevorzugt, 2,2'-Azo-bis-(2,4-dimethyl-4-methoxyvaleronitril). Das optimale Molekulargewicht ist von den gewünschten physikalischen Eigenschaften abhängig, z.B. der Lösungsviskosität und der Zugfestigkeit der Schicht. Für eine höhere Festigkeit ist ein höheres Molekulargewicht zweckmäßig, für optimale Lösungseigenschaften, die z.B. den Aufschleudervorgang beeinflussen, dagegen ein niedrigeres Molekulargewicht. Im allgemeinen liegen die günstigsten Molekulargewichte im Bereich von 10.000 bis 200.000.

Außer den oben beschriebenen Polymerisaten enthält das erfin-dungsgemäße Photoresistgemisch noch eine bei Belichtung Säure abspaltende Verbindung sowie ein Lösemittel und gegebenenfalls Stabilisatoren oder andere Zusätze.

Die bei Belichtung Säure abspaltende Verbindung dieser Erfindung wird aus einer Gruppe neutraler Substanzen gewählt, die nach der Reaktion mit aktinischer Strahlung eine Säure bilden können. Für die Wahl der Verbindung sind verschiedene Faktoren maßgebend, wie z.B. die Art der Strahlung, für die sie empfindlich sein soll. Natürlich muß die Säure abspaltende Verbindung bei der vorgesehenen Frequenz Strahlung absorbieren, aber sie muß die Strahlung auch wirksam in die zur Abspaltung der Polymeren notwendige Säure umwandeln. Vor dem Belichten ist die Säure abspaltende Verbindung nicht nur nicht sauer, sie darf vor dem Belichten mit aktinischer Strahlung auch nicht mit dem Polymeren reagieren und muß mit ihm verträglich sein, z.B.darf die Säure abspaltende Verbindung sich bei der Herstellung der Photoresistschicht nicht als ausgeprägte makroskopische Phase abtrennen. Außerdem darf sie nicht so flüchtig sein, daß sie dazu neigt, auf der aufgebrachten Schicht zu verdampfen. Im allgemeinen haben die bei Belichtung Säure abspaltenden Verbindungen einen Siedepunkt im Bereich von 150 - 200 °C oder höher. Die Säure abspaltende Verbindung soll bei Temperaturen unter etwa 90 °C nicht instabil sein, so daß die Möglichkeit besteht, eine Trocknungsbehandlung durchzuführen, mit der das Resistlösemittel vertrieben wird.

Geeignete Verbindungen sind z.B. die in US-PS 3,046,123 beschriebenen Sulfonsäureester von Naphthochinondiaziden oder die aus US-PS 3,981,897 und US-PS 4,450,360 bekannten Diazoniumsalze, Jodoniumsalze und Sulfoniumsalze oder organische Verbindungen wie Halohenkohlenwasserstoffe, wie sie in

US-PS 3,779,778, US-PS 3,515,552 und US-PS 3,536,489 beschrieben sind. Die aus den Sulfonsäureestern von Naphthochinondiaziden resultierenden Carbonsäuren sind zwar stark genug, um den Abbau zu bewirken, die bevorzugten Säuren sind aber die von Oniumsalzen oder Halogenkohlenwasserstoffen abgeleiteten stärkeren Säuren, wie Chlorwasserstoff-, Bromwasserstoff-oder Sulfonsäure.

Bei den Jodoniumsalzen handelt es sich vorzugsweise um Diaryljodoniumsalze, wie Di-4-methylphenyljodonium-, Di-4-methoxyphenyljodonium- und Diphenyljodoniumsalze.

Von den Sulfoniumsalzen werden vorzugsweise Triarylsulfoniumsalze verwendet, wie z.B. Tri-4-methylphenylsulfonium-, Tri-4-methoxyphenylsulfonium- und Triphenylsulfoniumsalz. Ganz besonders bevorzugt sind als Jodonium- oder Sulfoniumsalze die Perfluoralkansulfonate, wie geradkettige $C_1$ - $C_{10}$ - Alkansulfonate, z.B. Perfluorpentan-, Perfluoroctan-und Perfluormethansulfonate. Bei den Oniumsalzen kann es sich auch um Hexafluorphosphate, Tetrafluorborate oder Hexafluorarsenate handeln. Für die Verwendung in dieser Erfindung besonders geeignete Verbindungen sind z.B. 2,4-Benzophenon-di-(1-oxo-2-naphthochinondiazid-4-sulfonat), 4-Methylbenzoldiazoniumtetrafluorborat, Diphenyljodoniumhexafluorphosphat, Triphenylsulfoniumperfluoroctansulfonat, Tribromtrichlorethan, 2-4-Bis-(trichlormethyl)-6-p-methoxystyryl-s-triazin.

Die Oniumalze können ein Anion enthalten, daß fähig ist, aktinische Strahlung zu absorbieren und die Energie auf das Kation zu übertragen. Solche Anionen sind z.B. 4-Nitronaphthalin-1-sulfonat,4-Methoxynaphthalin-1-sulfonat oder Naphthochinonsulfonat.

Die zur Herstellung von Photoresistlösungen geeigneten Lösemittel sind z.B. die organischen Lösemittel, die keine freien Säuregruppen enthalten, wie z.B. Diethylenglykoldimethylether, Dimethylformamid, Cyclohexanon, Toluol, Xylol, Ethylen- oder Propylenglykolmonoethyletheracetat.

Es hat sich gezeigt, daß geringe Mengen an basischen Substanzen, wie z.B. Trialkylaminen, die Photoresistlösung stabilisieren, da sie die Fähigkeit besitzen, eventuell vorhandene oder bei der Lagerung entstehende Säurespuren zu binden. Die basische Substanz ist am vorteilhaftesten flüchtig, so daß sie nach dem Aufbringen des Photoresists auf den Schichtträger leicht aus der Schicht zu entfernen ist. Das gibt dem Photoresist während der anschließenden Verarbeitung seine volle Empfindlichkeit. Will man dagegen aus irgendeinem Grund einen für aktinisches Licht weniger empfindlichen Photoresist haben, kann es von Nutzen sein, nichtflüchtige basische Substanzen zu verwenden, die in der Schicht bleiben und einen Teil der photochemisch erzeugten Säure binden.

Das Photoresistgemisch kann nach verschiedenen bekannten Verfahren auf den Schichtträger aufgebracht werden. Dazu zählen beispielsweise Aufschleudern, Tauchen und Beschichten mit Walzen. Die für den Einsatz in der Mikrolithographie optimale Beschichtung ist 0,5 bis 2,5 µm dick und wird durch Aufschleudern aufgebracht. Nach dem Beschichten kann das Lösemittel durch Nachtrocknen bei einer Temperatur von 35 bis 90 °C für die Dauer von 1 bis 100 Minuten vertrieben werden. Die Photoresistschicht kann dann durch eine Belichtungsmaske mit aktinischer Strahlung belichtet werden, wobei ein latentes Bild entsteht. Es kann zwar auch mit Wellenlängen von 230 bis 500 nm belichtet werden, bevorzugt ist jedoch die Belichtung mit DUV (Wellenlängen von 245 bis 300 nm), für die Belichtungsenergien von 0,5 bis 50 mJ/cm$^2$ geeignet sind. Bei der Bestrahlung mit Elektronenstrahlen genügt eine Dosis von 1 bis 10 µC/cm$^2$. Bei der Elektronenstrahlbelichtung können höhere Dosen zur Vernetzung des Photoresists führen, der dann zu einem negativ arbeitenden Photoresist wird, während er bei der Bestrahlung mit DUV positiv arbeitet. Nach der Belichtung mit aktinischer Strahlung läßt man den resistbeschichteten Träger für die Dauer von 10 Sekunden bis zu 100 Minuten an der Umgebungsluft stehen, damit die Abspaltungsreaktion am Polymerisat ablaufen kann. Um die Abspaltungsreaktion zuendezuführen kann der Schichträger gegebenenfalls auf eine Temperatur von maximal etwa 130 °C erhitzt werden.

Nach der Abspaltungsreaktion an dem Polymerisat wird der Resist mit einem wäßrig-alkalischen Entwickler behandelt, der die verbliebene zweite blockierende Gruppe abspaltet und dann die belichteten Bereiche ablöst, so daß nur die unbelichteten Bereiche auf dem Schichtträger zurückbleiben. Geeignete Entwickler sind zum Beispiel wäßrige Lösungen von Alkalihydroxiden, quaternären Ammoniumhydroxiden und starken organischen Basen, wie z.B. Cholin. Ein bevorzugter Entwickler ist eine 0,1 normale Lösung von quaternären Ammoniumbasen (1:1 Tetramethylammoniumhydroxid/Tetrabutylammoniumhydroxid). Die Dauer der Entwicklung kann von 15 Sekunden bis zu 15 Minuten betragen. Die optimale Dauer liegt zwischen 1 und 2 Minuten; mit dem bevorzugten Entwickler werden etwa 2 Minuten benötigt.

Mit dem erfindungsgemäßen Gemisch können Reliefstrukturen hergestellt werden, die - ein wenig abhängig von der Zusammensetzung des Polymeren - gegen Temperaturen von etwa 230 °C beständig sind.

Beispiel 1

Herstellung von Methylolmaleinsäureimid

Zur Herstellung von Methylolmaleinsäureimid wurde ein modifiziertes Verfahren von Tawney et al. [ J. Org. Chem. (1961) 25, 157 ] angewandt.

In ein 600 ml fassendes Becherglas wurden 40,0 g umkristal-lisiertes Maleinsäureimid, 25 ml destilliertes Wasser, und 34 ml 37 %-ige Formalinlösung gegeben. Dann wurden unter Rühren 20 Tropfen Triethylamin zugegeben. Die Aufschlämmung wurde fünf Stunden bei Raumtemperatur gerührt. Anschließend wurde die Lösung mit 20 Tropfen konzentrierter HCl versetzt und erwärmt, um alle Feststoffe aufzulösen. Das Wasser wurde im Vakuum abgedampft und der resultierende Feststoff aus Chloroform umkristallisiert. Das erhaltene Produkt (Schmelzpunkt 107,5 - 109,5 °C) hatte eine Gewicht von 44,9 g; (Ausbeute 86 %).

Beispiel 2

Umsetzung von Methylolmaleinsäureimid mit 2-Methoxypropen

In einen 250 ml fassenden Rundkolben wurden 11,03 g trockenes Methylolmaleinsäureimid, 90 ml trockenes Chloroform und 16 ml 2-Methoxypropen gegeben. Das Gemisch wurde mit 10 g p-Toluolsulfonsäure versetzt und 70 Minuten gerührt, wonach der Feststoff sich aufgelöst hatte. Zur Neutralisierung der Säure wurden dann 0,5 g festes $Na_2CO_3$ zugesetzt. Die Lösung wurde filtriert und das Lösemittel abgedampft, so daß ein Öl zurückblieb, das sich beim Stehen verfestigte.Das erhaltene Produkt [N-(2,4-Dioxa-3,3-dimethylpentyl)-2H,5H-2,5-dioxypyrrol] (Schmelzpunkt 70,0 - 71,5 °C) hatte ein Gewicht von 16,9 g; (Ausbeute 98%). Ähnliche Ergebnisse ergaben sich, wenn man anstelle von 2-Methoxypropen 2-Ethoxypropen verwendete.

Beispiel 3

Umsetzung von Methylolmaleinsäureimid mit Ethylvinylether

In einen 25 ml fassenden Rundkolben wurden 0,20 g Methylol-maleinsäureimid, 2 ml $CH_2Cl_2$ und 0,15 ml Ethylvinylether gegeben. 2 Tropfen Trifluoressigsäure wurden hinzugefügt und das Gemisch zwei Stunden gerührt, wonach sich der Feststoff aufgelöst hatte. Dann wurden 100 mg $Na_2CO_3$ zugegeben, die Lösung wurde filtriert und das Lösemittel abgedampft. Als Ausbeute (58%) erhielt man 0,18 g (N-(2,4-Dioxa-3-methylhexyl)-2H,5H-2,5-dioxopyrrol), ein weißer Feststoff mit einem Schmelzpunkt von 99 - 100 °C.

Beispiel 4

Umsetzung von Methylolmaleinsäureimid mit Methylvinylether

In einen gekühlten, 50 ml fassenden Dreihalsrundkolben wurden 4 ml Methylvinylether und 30 ml Methylenchlorid gegeben. Während des Füllens wurde der Kolben mit einer Mischung aus Trockeneis und 2-Propanol gekühlt. Anschließend wurden 4,0 g trockenes Methylolmaleinsäureimid zusammen mit 5 mg p-Toluolsulfonsäure zugegeben. Die Lösung wurde auf Raumtemperatur erwärmt und gerührt. Nach zwei Stunden wurden weitere 5 mg p-Toluolsulfonsäure zugefügt. Zur Neutralisierung der Säure wurde nach 3 Stunden 0,5 g festes Kaliumcarbonat zugegeben. Die Lösung wurde dann filtriert und das Lösemittel im Vakuum abgedampft. Die resultierende Flüssigkeit wurde in 200 ml eines Pentan-Toluolgemisches (50 : 50)

gelöst, aus dem sich unumgesetztes Methylolmaleinsäureimid niederschlug. Der Feststoff wurde abfiltriert und das Filtrat im Vakuum eingeengt, wobei sich 4,75 g einer farblosen Flüssigkeit ergaben. Die Eigenschaften (des Reaktionsproduktes) stimmten mit der Struktur von N-(2,4Dioxa-3-methylpentyl)-2H,5H-2,5-dioxopyrrol überein.

Beispiel 5

Umsetzung von Methylolmaleinsäureimid mit Dihydropyran

Der Versuch aus Beispiel 3 wurde wiederholt, mit dem Unterschied, daß es sich bei dem verwendeten Vinylether um Dihydropyran handelte.

Beispiel 6

Umsetzung von Methylolmaleinsäureimid mit 5,6-Dihydro-4-methoxy-2H-pyran

Der Versuch aus Beispiel 3 wurde wiederholt, mit dem Unterschied, daß es sich bei dem verwendeten Vinylether um 5,6-Dihydro-4-methoxy-2H-pyran handelte.

Beispiel 7

Polymerisation von Styrol mit N-(2,4-Dioxa-3,3-dimethylpentyl)-2H,5H-2,5-dioxopyrrol

In einen 100 ml fassenden Rundkolben wurden 6,00 g N-(2,4-Dioxa-3,3-dimethylpentyl)-2H,2,5-dioxopyrrol, 32 ml Toluol, 2,12 g gereinigtes Styrol, 0,18 ml Dodecanthiol und 60 mg des Initiators Vazo 33 2,2′-Azobis-(2,4-dimethyl4-methoxyvaleronitril) gegeben. Das Gemisch wurde unter Rühren auf 35 °C erwärmt. Nach 2 Stunden und 30 Minuten wurde der Kolbeninhalt in Pentan gegossen, anschließend der Feststoff von dem Pentan abfiltriert, mit Methanol gewaschen und getrocknet. Es wurden 6,85 g eines weißen Feststoffes erhalten; (Ausbeute 75%).

Beispiel 8

Polymerisation von Styrol mit N-(2,4-Dioxa-3-methylpentyl)-2H,5H-2,5-dioxopyrrol

In einen 100 ml fassenden Rundkolben wurden 2,67 g gereinigtes Styrol, 4,75 g N-(2,4-Dioxa-3-methylpentyl)-2H,5H-2,5-Dioxopyrrol, 25 ml Toluol, 0,15 ml Dodecanthiol und 50 mg Vazo 33 gegeben. Das Gemisch wurde auf 35 °C erwärmt, 5 Stunden gerührt und anschließend in 80 ml Pentan gegossen. Die Feststoffe wurden von dem Pentan abfiltriert und zunächst mit Pentan und dann mit Ethylether gewaschen und in einem Stickstoffgasstrom getrocknet. Die Polymerausbeute betrug 6,34 g (85% d.Th.).

Beispiel 9

Polymerisation von Styrol mit N-(2,4-Dioxa-3-methylhexyl)-2H,5H-2,5-dioxopyrrol

Der Versuch aus Beispiel 7 wurde wiederholt, wobei jedoch anstelle des dort verwendeten Monomers N-(2,4-Dioxa-3-methylhexyl)-2H,5H-2,5-dioxopyrrol genommen wurde.

Beispiel 10

Polymerisation von Styrol mit N-(2-Tetrahydropyranyloxymethyl)-2H,5H-2,5-dioxopyrrol

Der Versuch aus Beispiel 7 wurde wiederholt, wobei jedoch anstelle des dort verwendeten Monomers N-(2-Tetrahydropyranyloxymethyl)-2H,5H-2,5-dioxopyrrol genommen wurde.

Beispiel 11

Polymerisation von Styrol mit N-(4-Methoxy-4-tetrahydropyranyl-oxymethyl)-2H,5H-2,5-dioxopyrrol

Der Versuch aus Beispiel 7 wurde wiederholt, wobei jedoch anstelle des dort verwendeten Monomers N-(4-Methoxy-4tetrahydropyranyloxymethyl)-2H,5H-2,5-dioxopyrrol genommen wurde.

Beispiel 12

Polymerisation von α-Methylstyrol mit N-(2,4-Dioxa-3,3-dimethylpentyl)-2H,5H-2,5-dioxopyrrol

Der Versuch aus Beispiel 7 wurde wiederholt, wobei jedoch α-Methylstyrol anstelle von Styrol genommen wurde und die Reaktionszeit wegen der langsameren Copolymerisation auf 8 Stunden verlängert wurde.

Beispiel 13

Polmerisation von Decylvinylether mit N-(2,4-Dioxa-3,3-dimethylpentyl)-2H,5H-2,5-dioxopyrrol

Der Versuch aus Beispiel 7 wurde wiederholt, wobei jedoch Decylvinylether anstelle von Styrol genommen und die Reaktionszeit auf 4 Stunden verlängert wurde.

Beispiel 14

Die Alkalilöslichkeit eines Methylolmaleinsäureimid/Styrol-Coplymers

Es wurde ein Styrol/Methylolmaleinsäureimid-Copolymer hergestellt, indem Styrol (0,9 g) mit Methylolmaleinsäureimid (1,0 g) in 10 ml Cyclohexanon bei 70 °C mit Azo-bis-isobutyronitril als Initiator für die Dauer von 3 Stunden coplymerisiert wurde. Das Polymer wurde durch Verreiben des festen, erkalteten Reaktionsgemisches mit Methanol isoliert. Eine Probe des Polymers wurde einer $^1$H-NMR-Analyse unterzogen und zeigte ein mit der festgelegten Zusammensetzung übereinstimmendes Spektrum. Ein IR-Spektrum

einer aus einer Lösung in DMF aufgebrachten Schicht zeigte eine Absorptionsbande in dem Bereich, in dem OH-Streckschwingungen erwartet wurden. Das Polymer erwies sich als wasserunlöslich, war jedoch in einer verdünnten Tetramethyl-ammoniumhydroxid-Lösung löslich. Eine mit Ammoniakdampf behandelte Schicht ergab ein IR-Spektrum, das nicht mehr die mit der $-CH_2-OH$-Gruppe verknüpfte Absorptionsbande aufwies, sondern mit dem Spektrum von Maleinsäureimid-Styrol-Copolymeren übereinstimmte.

Beispiel 15

Herstellung und Verwendung eines Photoresists

Zur Herstellung einer Photoresistlösung wurden 1 Teil Diphenyljodoniumtrifluormethansulfonat und 9 Teile des Harzes aus Beispiel 7 in 39,7 Teilen 2-Methoxyethylether gelöst. Die Resistlösung wurde durch ein PTFE-Filter mit einer Porengröße von 0,2 µm in ein sauberes Glasgefäß filtriert. Die filtrierte Lösung wurde mit einer Lackschleuder (Fa. Headway Research) bei 3000 U/min auf saubere Siliziumwafer aufgeschleudert. Nach dem Beschichten wurden die Wafer 15 Minuten auf 80 °C erhitzt, um Lösemittelreste zu vertreiben. Die Wafer wurden dann mittels einer mit DUV-Optik ausgerüsteten Hg-Xe-Lichtquelle mit 500 W Leistung (Baureihe 30 des Herstellers Optical Associates) mit DUV-Licht belichtet.

Das Ausgangslicht wurde zusätzlich durch ein für 260 ± 15 nm durchlässiges Filter (Omega Optical) geleitet, um sicherzustellen, daß nur DUV-Licht auf den Photoresist auftraf. Die lithographische Struktur wurde mit einer im Vakuumkontakt mit der Waferoberfläche gehaltenen Chrom-Maske aus Quarz (Optoline, Ditric Optics) hergestellt. Nach dem Belichten wurden die Wafer durch Eintauchen in eine 0,1 normale Lösung von quaternären Ammoniumbasen (Tetramethylammoniumhydroxid/Tetrabutylammoniumhydroxid im Verhältnis 1:1 gemischt) für die Dauer von 1 Minute entwickelt und dann mit entionisiertem Wasser abgespült. Die belichteten Bereiche wurden mit einer Belichtungsenergie von 2,2 $mJ/cm^2$ vollständig ausbelichtet. Linien und Graben-Strukturen von 1µm auf der Maske waren in dem Photoresist gut aufgelöst und bildeten eine Mikroreliefstruktur auf der Oberfläche der Silizium-Wafer.

Beispiel 16

Es wurden resistbeschichtete Wafer wie in Beispiel 15 beschrieben hergestellt und belichtet, wobei jedoch die Wafer nach dem Belichten und vor dem Entwickeln für die Dauer von 1 Minute auf 55 °C erhitzt wurden. Die nacherhitzten Wafer wurden 1,5 Minuten in dem in Beispiel 15 beschriebenen Entwickler entwickelt und ergaben eine ausentwickelte positive Reliefstruktur auf dem Silizium. Die zur vollständigen Ausbelichtung erforderliche Belichtungsenergie betrug 1,5 $mJ/cm^2$. Daraus ist ersichtlich, daß der Photoresist sowohl mit als auch ohne Nacherhitzungsschritt zwischen Belichten und Entwickeln verarbeitet werden kann.

Beispiel 17

Aus einem Teil Diphenyljodoniumtrifluormethansulfonat, 12 Teilen des in Beispiel 7 hergestellten Polymers und 43,5 Teilen eines eine Spur Triethylamin enthaltenden 2-Methoxyethylesters wurde eine Photoresistlösung hergestellt. Die Photoresistlösung wurde filtriert und auf 5 Zoll große, oxidierte Silizium-Wafer, wie in Beispiel 15, aufgeschleudert und erhitzt. Die beschichteten Wafer wurden mit einem Projektionsbelichtungsgerät der Marke Perkin-Elmer Micralign TM-500 im UV2-Bereich (DUV) mit einer Bestrahlungsdosis von 12 $mJ/cm^2$ belichtet. Nach dem Belichten und vor dem Entwickeln wurden die Wafer nach drei verschiedenen Verfahrensweisen thermisch behandelt: 1.) drei Minuten bei Raumtemperatur, 2.) eine Minute bei 70 °C und 3.) eine Minute bei 97 °C. Die anschließende Entwicklung dauerte in allen Fällen 2 Minuten in dem Entwickler aus Beispiel 15. Alle drei Verfahrensweisen führten zu gut aufgelösten Linien und Graben-Strukturen der Nennabmessung 1 µm. Eine Untersuchung unter dem Rasterelektronenmikroskop ergab, daß die Linienbreiten und Profile gleich waren, woraus ersichtlich ist, daß bei diesem

Material für die nach dem Belichten angewendete Temperatur ein viel größerer Spielraum besteht als bei dem Poly-(N-tert.-butyloxycarbonyl-maleinsäureimid-costyrol) aus U.S.-Patentanmeldung, Serial No. 832,116. Ferner zeigt dieses Beispiel, daß eine zur Säurebindung zugesetzte Spur von flüchtigem Amin das lithographische Verfahren nicht beeinträchtigt, wenn die Wafer vor dem Belichten erhitzt werden.

Beispiel 18

Es wurde eine Photoresistlösung nach dem in Beispiel 15 beschriebenen Verfahren hergestellt, wobei jedoch das Polymer aus Beispiel 12 verwendet wurde. Der Photoresist wurde nach dem Verfahren aus Beispiel 15 filtriert, aufgebracht, belichtet und entwickelt und ergab hochaufgelöste Reliefstrukturen.

Beispiel 19

Es wurde eine Photoresistlösung nach dem in Beispiel 15 beschriebenen Verfahren hergestellt, wobei jedoch das Polymer aus Beispiel 13 verwendet wurde. Der Photoresist wurde nach dem Verfahren aus Beispiel 15 filtriert, aufgebracht, belichtet und entwickelt und ergab hochaufgelöste Reliefstrukturen.

Beispiel 20

Es wurde eine Photoresistlösung nach dem in Beispiel 15 beschriebenen Verfahren hergestellt, wobei jedoch das Polymer aus Beispiel 9 verwendet wurde. Der Photoresist wurde nach dem Verfahren aus Beispiel 16 filtriert, aufgebracht, belichtet und entwickelt und ergab hochaufgelöste Reliefstrukturen.

Beispiel 21

Es wurde eine Photoresistlösung nach dem in Beispiel 15 beschriebenen Verfahren hergestellt, wobei jedoch das Polymer aus Beispiel 10 verwendet wurde. Der Photoresist wurde nach dem Verfahren aus Beispiel 16 filtriert, aufgebracht, belichtet und entwickelt und ergab hochaufgelöste Reliefstrukturen.

Beispiel 22

Es wurde eine Photoresistlösung nach dem in Beispiel 15 beschriebenen Verfahren hergestellt, wobei jedoch das Polymer aus Beispiel 11 verwendet wurde. Der Photoresist wurde nach dem Verfahren aus Beispiel 16 filtriert, aufgebracht, belichtet und entwickelt und ergab hochaufgelöste Reliefstrukturen.

Beispiel 23

Es wurde eine Photoresistlösung nach dem in Beispiel 15 beschriebenen Verfahren hergestellt, wobei jedoch das Polymer aus Beispiel 8 verwendet wurde. Der Photoresist wurde nach dem Verfahren aus Beispiel 16 filtriert, aufgebracht, belichtet, nacherhitzt und entwickelt. Es entstand eine hochaufgelöste Reliefstruktur. In den bestrahlten Bereichen kam es zu einem gewissen Grad an Vernetzung, und die Ausentwicklung von kleinen Löchern war beeinträchtigt.

Vergleichsbeispiel 24

0,1 g Maleinsäureimid, 1 ml Toluol und 0,15 ml 2-Methoxypropen wurden in einem Rundkolben miteinander vermischt. Das Gemisch wurde mit 0,5 mg p-Toluolsulfonsäure als Katalysator versetzt. Anders als in Beispiel 2, in dem Methylolmaleinsäureimid anstelle von Maleinsäureimid verwendet wurde, wurde die Lösung zunächst gelb und dann rot-orange. Nach 30 Minuten war die Lösung nahezu undurchsichtig.

Das feste Maleinsäureimid löste sich nicht auf. Das Lösemittel wurde in einem Stickstoffgasstrom verdampft und der Rückstand einer $^1$H-NMR-Analyse unterzogen. Der einzige identifizierbare Stoff war unumgesetztes Maleinsäureimid. Daraus wurde geschlossen, daß die gewünschte Reaktion zwischen und 2-Methoxypropen nicht stattgefunden hatte.

Vergleichsbeispiel 25

Ein Poly(N-methylol-maleinsäureimid-co-styrol) wurde in N,N-Dimethylformamid gelöst und auf polierte Natriumchlorid-Scheiben aufgeschleudert. Die Scheiben wurden 20 Minuten bei 80 °C nacherhitzt, um das Lösemittel zu vertreiben. Das trockene Polymer blieb als 1 µm dicke transparente Schicht auf den Scheiben zurück. Die Scheiben wurden in den Probestrahlengang eines Infrarot-Spektrometers der Marke Perkin-Elmer gebracht, und das Infrarotspektrum des Polymers aufgezeichnet. Eine Scheibe wurde für die Dauer von 30 Minuten in einen geschlossenen Behälter mit HCl-Dampf gelegt und nach der Entnahme aus dem Behälter 10 Minuten bei 130 °C nacherhitzt. Nach der Säurebehandlung war das Infrarotspektrum der Schicht mit dem der unbehandelten Schicht identisch, was darauf hinwies, daß die Säure keine Abspaltungsreaktion an dem Polymer bewirkt hatte.

Eine andere polymerbeschichtete Scheibe wurde 20 Minuten mit Ammoniakdampf behandelt. Das anschließend erstellte Infrarotspektrum unterschied sich erheblich von dem der unbehandelten Scheibe. Die der Methylolgruppe zugeordneten Absorptionsbanden bei 1060 $cm^{-1}$ und 3475 $cm^{-1}$ waren verschwunden, was darauf hinwies, daß durch die Base das Polymer abgespalten wurde.

In einer weiteren Probe wurde das Polymer bei 190 °C thermisch abgebaut. Das Infrarotspektrum zeigte, daß die Methylolgruppe entfernt worden war und die dem freien Imid zugeordnete Absorptionsbande bei 3280 $^{-1}$ erschienen.

Daraus wurde geschlossen, daß aus Methylolmaleinsäureimid hergestellte Polymere nicht für positive, unter Säureeinfluß Gruppen abspaltende Photoresists geeignet sind, sondern den Zusatz von erfindungsgemäßen blockierenden Gruppen benötigen.

Vergleichsbeispiel 26

Poly(p-tert.-butyloxycarbonyloxystyrol) wurde nach dem in Beispiel D-1 von US-A-4,491,628 beschriebenen Verfahren hergestellt. Zur Herstellung einer Photoresistlösung wurden 1 Teil Diphenyljodoniumtrifluormethansulfonat und 9 Teile Poly(p-tert.-butyloxycarbonyloxystyrol) in 23,3 Teilen 2-Methoxyethylether gelöst. Mit der Lösung wurden Silizium-Wafer beschichtet, die dann wie in Beispiel 16 beschrieben verarbeitet wurden, wobei jedoch die Nacherhitzung nach dem Belichten während 2 Minuten bei 90 °C durchgeführt wurde und der Entwickler eine 0,5 normale Lösung war. Die zur Ausbelichtung der belichteten Bereiche benötigte Belichtungsenergie betrug 3 bis 4 $mJ/cm^2$ (verglichen mit 1,5 $mJ/cm^2$ in Beispiel 16). Die Photoresistbilder wurden dann erhitzt, um den für sie geeigneten Temperaturbereich zu ermitteln. Bei 120 °C kam es zu einem Abrunden (beginnendes Fließen) der Bilder, während die in Beispiel 16 hergestellten Bilder bei Temperaturen bis zu 220 °C keinerlei Abrunden zeigten. Das Verhalten von erfindungsgemäßen Photoresistgemischen ist also dem der Photoresistgemische aus US-A-4,491,628 überlegen.

Beispiel 27

Es wurde ein Photoresistgemisch wie in Beispiel 15 hergestellt, wobei jedoch Diphenyljodoniumtetraphenylborat anstelle von Diphenyljodoniumtrifluormethansulfonat verwendet wurde. Wafer wurden wie in Beispiel 16 beschrieben hergestellt und verarbeitet. Das Photoresistgemisch zeigte selbst bei Bestrahlungsdosen bis zu 200 $mJ/cm^2$ keinerlei Tendenz zum Löslichwerden in wäßriger Base. Daraus wurde geschlossen, daß die Anwesenheit einer Diphenyljodoniumgruppe (oder anderen Oniumgruppe) für die Kennzeichnung brauchbarer Verbindungen dieser Art unzureichend ist und daß das Anion sich zu einer Brönsted-Säure umsetzen lassen muß. Es wäre also zu erwarten, daß die verwandte Verbindung Diphenyljodoniumtetrafluorborat als Photosensibilisator wirkt.

Beispiel 28

Es wurde ein Photoresist wie in Beispiel 15 hergestellt, wobei jedoch Trijodmethan anstelle von Diphenyljodoniumtrifluormethansulfonat verwendet wurde. Wafer wurden wie in Beispiel 16 beschrieben hergestellt und verarbeitet. Zur Ausbelichtung des Resists aus dem belichteten Bereich mußten die Testbilder mit 14 mJ/cm$^2$ bestrahlt werden. Daraus wurde geschlossen, daß organische Verbindungen mit Kohlenstoff-Halogen-Bindungen als bei Belichtung Säure abspaltende Verbindungen für diese Erfindung geeignet sind.

## Ansprüche

1. Photoresistgemisch, enthaltend

a) ein Polymer mit Imidgruppen, die durch an Acetal- oder Ketaleinheiten gebundene Methylol- oder substituierte Methylolgruppen blockiert sind,

b) eine bei Belichtung Säure abspaltende Verbindung in einer Menge, die ausreicht, die Acetal- oder Ketaleinheiten durch die photolytisch bei einer erwünschten Wellenlänge gebildete Säure abzuspalten und

c) ein Lösemittel, das geeignet ist, das Polymer nach a) und die Verbindung nach b) zu lösen.

2. Gemisch nach Anspruch 1, dadurch gekennzeichnet, daß das Polymer ein Homopolymer eines blockierten Maleinsäureimids ist.

3. Gemisch nach Anspruch 1, dadurch gekennzeichnet, daß das Polymer ein Copolymerisat ist, das nicht mehr als fünf Comonomereinheiten pro blockierter Imidgruppe besitzt.

4. Gemisch nach Anspruch 1, dadurch gekennzeichnet, daß das Polymer ein Copolymerisat ist, das etwa eine Comonomereinheit pro blockierter Imidgruppe besitzt.

5. Photoresistgemisch nach Anspruch 1, enthaltend

a) 60 - 99 Gewichtsprozent, bezogen auf die nichtflüchtigen Bestandteile, des Imidgruppen haltigen Polymers folgender allgemeiner Formeln

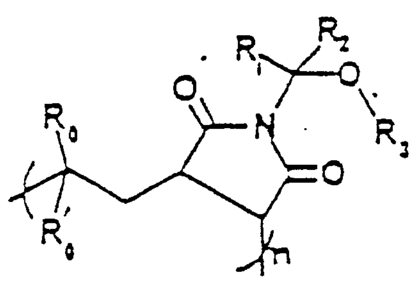

oder

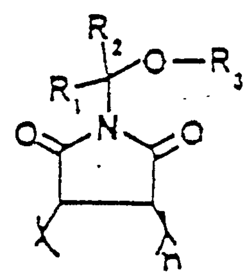

worin

$R_0$ Wasserstoff oder Methyl

$R_0'$ Aryl, Alkoxy oder Aryloxy,

$R_1$ und $R_2$ Wasserstoff oder ($C_1$ - $C_4$)-Alkyl,

$R_3$

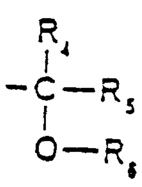

,

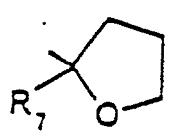

,

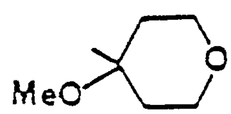

oder

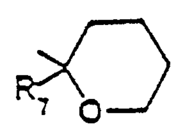

mit

$R_4$, $R_5$ Wasserstoff oder ($C_1$ - $C_4$)-Alkyl

$R_6$ ($C_1$ - $C_{10}$)-Alkyl

$R_7$ Wasserstoff oder ($C_1$ - $C_4$)-Alkyl

bedeuten,

b) 1 bis 40 Gewichtsprozent, bezogen auf die nichtflüchtigen Bestandteile, der bei Belichtung Säure abspaltenden Verbindung und

c) 1 bis 9 Gewichtsteile, bezogen auf die nichtflüchtigen Bestandteile, eines Lösemittels, das geeignet ist, das Polymer nach a) und die Verbindung nach b) zu lösen.

6. Gemisch nach Anspruch 5, worin

$R_0'$ Aryl oder substituiertes Aryl, vorzugsweise Phenyl, bedeutet.

7. Gemisch nach Anspruch 5, worin

$R_0'$ $-(C_1-C_{10})$-Alkoxy, vorzugsweise n-Decyloxy bedeutet.

8. Gemisch nach Anspruch 5, worin

$R_3$ $-C(CH_3)_2-O-CH_3$ oder $-CH(CH_3)-O-CH_3$ und

$R_0'$ Phenyl bedeuten.

9. Gemisch nach Anspruch 5, worin

$R_3$ 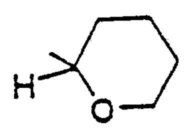 oder 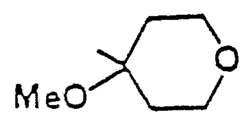 und

$R_0'$ Phenyl bedeuten.

10. Gemisch nach Anspruch 1, dadurch gekennzeichnet, daß als bei Belichtung Säure abspaltende Verbindung ein Sulfonsäureester eines Naphthochinondiazids, Omniumsalze oder ein Halogenid vorhanden sind.

11. Gemisch nach Anspruch 1, dadurch gekennzeichnet, daß als bei Belichtung Säure abspaltende Verbindung ein Jodoniumsalz vorhanden ist.

12. Gemisch nach Anspruch 1, dadurch gekennzeichnet, daß als Jodoniumalz ein Diaryljodoniumsalz, insbesondere Di-4-methylphenyl-, Di-4-methoxyphenyl- oder Diphenyljodoniumsalz vorhanden ist.

13. Gemisch nach Anspruch 1, dadurch gekennzeichnet, daß als bei Belichtung Säure abspaltende Verbindung ein Sulfoniumsalz vorhanden ist.

14. Gemisch nach Anspruch 13, dadurch gekennzeichnet, daß als Sulfoniumsalz ein Triarylsulfoniumsalz, insbesondere Tri-4-methylphenyl-, Tri-4-methoxyphenyl- oder Triphenylsulfoniumsalz vorhanden ist.

15. Gemisch nach Anspruch 1, dadurch gekennzeichnet, daß als bei Belichtung Säure abspaltende Verbindung ein Onium-salz mit einem Perfluoralkansulfonatanion vorhanden ist.

16. Gemisch nach Anspruch 15, dadurch gekennzeichnet, daß als Anion ein geradkettiges $(C_1 - C_{10})$-Alkansulfonat, vorzugsweise ein Perfluorpentan-, Perfluoroktan- oder Perfluormethan-sulfonat vorhanden ist.

17. Gemisch nach Anspruch 11 oder 13, dadurch gekennzeichnet, daß das Oniumsalz ein Hexafluorphosphat-, Tetrafluorborat-oder Hexafluorarsenat-anion enthält.

18. Gemisch nach Anspruch 1, dadurch gekennzeichnet, daß als bei Belichtung Säure abspaltende Verbindung ein Halogenkohlenwasserstoff mit geringer Flüchtigkeit vorhanden ist.

19. Gemisch nach Anspruch 18, dadurch gekennzeichnet, daß als Halogenkohlenwasserstoff 2,4-Bis-(trichlormethyl)6-p-methoxystyryl-s-triazin vorhanden ist.

20. Gemisch nach Anspruch 11 oder 13, dadurch gekennzeichnet, daß das Jodonium- oder Sulfoniumsalz ein Anion enthält, das in der Lage ist, aktinische Strahlung zu absorbieren und die aufgenommene Energie auf das Kation zu übertragen.

21. Photoresistmaterial bestehend aus einem Substrat und einer lichtempfindlichen Schicht, enthaltend

a) ein Polymer mit Imidgruppen, die durch an Acetal- oder Ketaleinheiten gebundene Methylol- oder substituierte Methylolgruppen blockiert sind, und

b) eine bei Belichtung Säure abspaltende Verbindung in einer Menge, die ausreichend ist, die Acetal- oder Ketaleinheiten durch die photolytisch bei einer erwünschten Wellenlänge gebildeten Säure abzuspalten.

22. Blockiertes Maleinsäureimidderivat der Formel

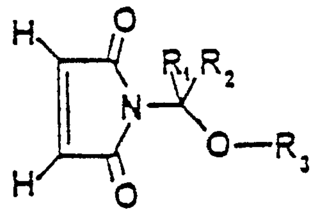

worin
$R_1$ und $R_2$ Wasserstoff der ($C_1$ - $C_4$)-Alkyl und
$R_3$

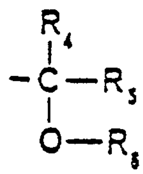

mit
$R_4$ und $R_5$ Wasserstoff oder ($C_1$ - $C_4$)-Alkyl und
$R_6$ ($C_1$ - $C_{10}$)-Alkyl

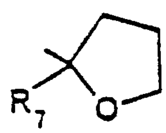

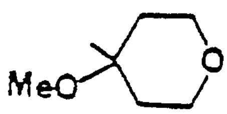

oder

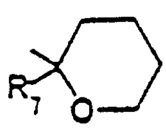

mit
$R_7$ Wasserstoff oder ($C_1$ - $C_4$)-Alkyl
bedeuten.

23. Maleinsäureimidderivate nach Anspruch 22 mit den Formeln: